# EUROPEAN PATENT APPLICATION

(11) **EP 3 499 568 A1**
(43) Date of publication of application: **19.06.2019**
(21) Application number: 18196326.5
(22) Date of filing: 24.09.2018
(51) Int. Cl.: H01L 23/538, H01L 25/03

(54) **ELECTRONIC DEVICE AND ELECTRONIC EQUIPMENT**

(30) Priority: 18.12.2017 JP 2017241957
(71) Applicant: Renesas Electronics Corporation, 135-0061 Tokyo (JP)
(72) Inventor: KAYASHIMA, Yuji, Koutou-ku, Tokyo 135-0061 (JP)
(74) Representative: Betten & Resch

(57) **Abstract**

The characteristics of an electronic device can be improved. The electronic device includes a first redistribution layer formed over an upper surface US of a sealing body, and a second redistribution layer formed below a bottom surface of the sealing body. The thickness of the second redistribution layer is smaller than the thickness of the first redistribution layer.

## Description

### CROSS-REFERENCE TO RELATED APPLICATIONS

The disclosure of Japanese Patent Application No. 2017-241957 filed on December 18, 2017 including the specification, drawings and abstract is incorporated herein by reference in its entirety.

### BACKGROUND

The present invention relates to a technique that is effectively applied to an electronic device and electronic equipment over which the electronic device is mounted.

Japanese Unexamined Patent Application Publication No. 2006-19433 (Patent Literature 1) describes a technique that relates to a semiconductor device having a first semiconductor element buried in the interior of a wiring substrate, and a second semiconductor element mounted over the wiring substrate.

### SUMMARY

For example, the present inventors have studied the improvement in the performance of an electronic device having a so-called POP (Package On Package) structure in which a semiconductor device (semiconductor package) is mounted over a sealing body (package structure body) in which a semiconductor chip is buried. As a result, in particular, it is apparent that the electronic device having the POP structure is required to be improved from the viewpoint of the heat release characteristic and the electric characteristic thereof. From this, the electronic device having the POP structure is required to be contrived for improving the characteristics thereof.

Other problems and novel features will be apparent from the description herein and the accompanying drawings.

An electronic device according to an embodiment includes a first wiring formed over an upper surface of a sealing body, and a second wiring formed below a bottom surface of the sealing body. The thickness of the second wiring is smaller than the thickness of the first wiring.

According to the embodiment, the characteristics of the electronic device can be improved.

### BRIEF DESCRIPTION OF THE DRAWINGS

Fig. 1A is a diagram illustrating a structure body of a System In Package, Fig. 1B is a diagram illustrating an example of a structure body having a POP structure, and Fig. 1C is a diagram illustrating another example of the structure body having the POP structure;
Fig. 2 is a schematic diagram illustrating the cross-sectional structure of the structure body illustrated in Fig. 1B;
Fig. 3 is a schematic diagram illustrating the cross-sectional structure of the structure body illustrated in Fig. 1C;
Fig. 4 is a cross-sectional view illustrating a structure body structuring an electronic device according to an embodiment;
Fig. 5 is a schematic cross-sectional view illustrating the structure of part of electronic equipment according to the embodiment;
Fig. 6 is a cross-sectional view illustrating a process for manufacturing the electronic device according to the embodiment;
Fig. 7 is a cross-sectional view illustrating the process for manufacturing the electronic device, continued from Fig. 6;
Fig. 8 is a cross-sectional view illustrating the process for manufacturing the electronic device, continued from Fig. 7;
Fig. 9 is a cross-sectional view illustrating the process for manufacturing the electronic device, continued from Fig. 8;
Fig. 10 is a cross-sectional view illustrating the process for manufacturing the electronic device, continued from Fig. 9;
Fig. 11 is a cross-sectional view illustrating the process for manufacturing the electronic device, continued from Fig. 10;
Fig. 12 is a cross-sectional view illustrating the process for manufacturing the electronic device, continued from Fig. 11;
Fig. 13 is a cross-sectional view illustrating the process for manufacturing the electronic device, continued from Fig. 12;
Fig. 14 is a cross-sectional view illustrating the structure body structuring the electronic device according to a first modification; and
Fig. 15 is a cross-sectional view illustrating the structure body structuring the electronic device according to a second modification.

### DETAILED DESCRIPTION

For convenience in description, the following embodiment is divided into a plurality of sections or embodiments, if necessary. However, unless otherwise specified, they are not mutually unrelated, and one of them is related to the modifications, details, supplementary descriptions, and the like of part or all of the others.

In addition, in the following embodiment, when referring to the number of each element including number of pieces, numerical value, amount, range, and the like thereof, it is not limited to a specific number, and may be more than or less than the specific number, unless otherwise specified and except for the case where it is apparently limited to the specific number in principle, and the like.

Further, in the following embodiment, needless to say, each component including an element step, and the like thereof is not always required, unless otherwise specified and except for the case where it is considered that it is apparently required in principle, and the like.

Likewise, in the following embodiment, when referring to the shape, position relation, and the like of each component and the like, a shape, position relation, and the like that are substantially approximate or similar thereto are included, unless otherwise specified and except for the case where it is considered that they are not apparently substantially approximate or similar thereto in principle, and the like. This is ditto for the above-described numerical value and range.

Furthermore, in all the drawings for illustrating the embodiment, the same members are, as a rule, indicated by similar reference signs, and their repeated description is omitted. It should be noted that to simplify the drawings, the drawings are sometimes hatched even when they are plan views.

### <The size reduction of an electronic device>

In the industrial field including in-vehicle application, security camera application, and the like, required is an electronic device including a high-speed memory and a control circuit having an interface with the high-speed memory and performing data processing and data transfer at high speed. And, for example, the above-described electronic device can include a structure body having a semiconductor device (semiconductor component) including the high-speed memory, and a semiconductor chip formed with the control circuit controlling the high-speed memory, the semiconductor device and the semiconductor chip being integrally mounted.

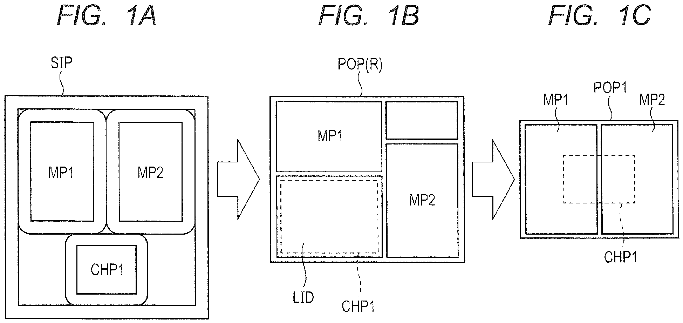

Here, Fig. 1A is a schematic diagram illustrating a structure body SIP called a so-called System In Package, the structure body SIP having a structure including two semiconductor devices MP1 and MP2 including high-speed memories, and a semiconductor chip CHP1 formed with a control circuit controlling the high-speed memories, the semiconductor devices MP1 and MP2 and the semiconductor chip CHP1 being horizontally arranged over a wiring substrate. In Fig. 1A, in the structure body SIP called the System In Package, since the two semiconductor devices MP1 and MP2 and the semiconductor chip CHP1 are horizontally arranged, it is difficult to reduce the electronic device in size. In this regard, the request to reduce the electronic device in size has been recently increased, and thus, a structure body POP(R) that can reduce the electronic device in size, as compared with the structure body called the System In Package, has been studied.

Fig. 1B is a schematic diagram illustrating the structure of the structure body POP(R) in which the two semiconductor devices including the high-speed memories and a lid LID that is a heat releasing member are arranged over a package structure body in which the semiconductor chip CHP1 is buried. In the structure body POP(R), a redistribution layer RDL including a fine wiring (redistribution wiring) formed by the application of the wafer process technique is formed below the bottom surface of a sealing body in which the semiconductor chip CHP1 is buried. That is, the wiring formed in the redistribution layer RDL is much finer than the wiring formed over the wiring substrate of the structure body SIP called the System In Package illustrated in Fig. 1A. Thus, in the structure body POP (R) illustrated in Fig. 1B, the plane size of a sealing body SS in which the semiconductor chip CHP1 is buried can be smaller than the plane size of the wiring substrate of the structure body SIP illustrated in Fig. 1A. As a result, the electronic device including the structure body POP(R) illustrated in Fig. 1B can be smaller than the electronic device including the structure body SIP called the System In Package illustrated in Fig. 1A.

It should be noted that herein, the "redistribution layer" is a wiring layer including the fine wiring formed by the application of the wafer process technique, and is defined as a wiring layer formed over/below the sealing body (package structure body) sealing the semiconductor chip, not in the interior of the semiconductor chip. In particular, for example, the "redistribution layer" is used for clarifying that the redistribution layer is different from the wiring pattern formed over the wiring substrate used in the System In Package. The wiring included in the "redistribution layer" is formed by the application of the wafer process technique enabling fine processing, and thus has a size that is much smaller than the size of the wiring pattern formed over a typical wiring substrate (fine pattern).

In addition, herein, the "wafer process technique" includes, for example, a technique in which an opening is formed in a polyimide resin film by using the photolithography technique, and a copper film is then formed in the interior of the opening by using the plating method, thereby forming a copper wiring, and the like.

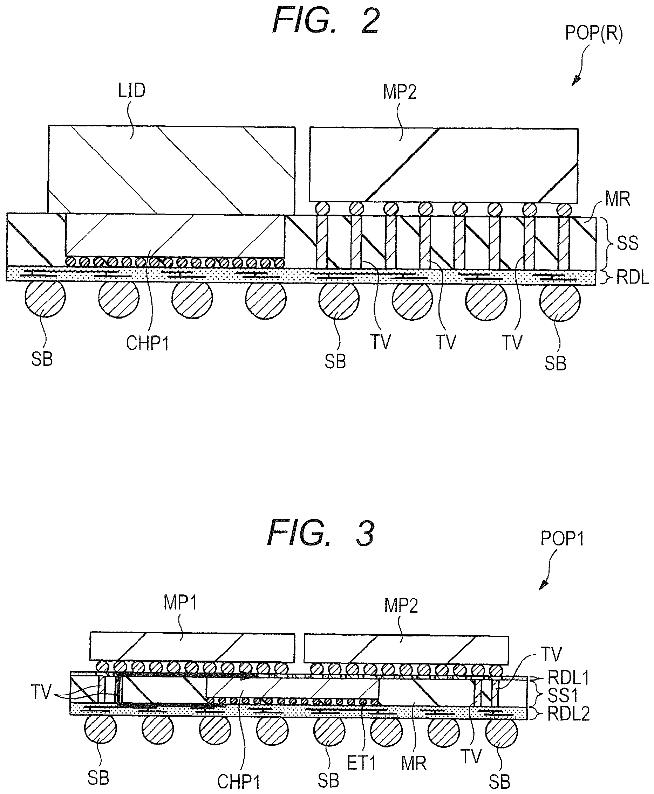

Fig. 2 is a schematic diagram illustrating the cross-sectional structure of the structure body POP(R) illustrated in Fig. 1B. In Fig. 2, the structure body POP(R) has the sealing body SS in which the semiconductor chip CHP1 is buried in a resin MR. The redistribution layer RDL including the fine wiring formed by the application of the wafer process technique is formed below the bottom surface of the sealing body SS. The fine wiring formed in the redistribution layer RDL is electrically coupled to the semiconductor chip CHP1 buried in the resin, and is also electrically coupled to through vias TV passing through the resin MR. And, as illustrated in Fig. 2, the semiconductor device MP2 electrically coupled to the through vias TV is mounted over the upper surface of the sealing body SS having the semiconductor chip CHP1 and the through vias TV, and the lid LID is provided at the position overlapped with the semiconductor chip CHP1 in plan view. On the contrary, solder balls SB functioning as external terminals are arranged through the redistribution layer RDL below the bottom surface of the sealing body SS. In the structure body POP(R) structured in this way, the redistribution layer RDL formed below the bottom surface of the sealing body SS is formed by the wafer process technique enabling fine processing, so that the plane size of the entire structure body POP(R) illustrated in Fig. 2 can be smaller.

However, as illustrated in Fig. 1C, a structure body POP1 that can further reduce the electronic device in size, as compared with the structure body POP (R) illustrated in Fig. 1B, has been recently studied. Fig. 1C is a schematic diagram illustrating the structure body POP1 according to a related art. The structure body POP1 according to the related art illustrated in Fig. 1C has a structure in which only the two semiconductor devices including the high-speed memories are arranged over the sealing body in which the semiconductor chip CHP1 is buried, and can reduce the electronic device in size, as compared with the structure body POP(R) illustrated in Fig. 1B.

Fig. 3 is a schematic diagram illustrating the cross-sectional structure of the structure body POP1 illustrated in Fig. 1C. The structure body POP1 illustrated in Fig. 3 has a redistribution layer RDL1 formed over the upper surface of a sealing body SS1 by the application of the wafer process technique, and a redistribution layer RDL2 formed below the bottom surface of the sealing body SS1 by the application of the wafer process technique. That is, unlike the structure body POP(R) illustrated in Fig. 2 in which the redistribution layer RDL is formed only below the bottom surface of the sealing body SS, in the structure body POP1 illustrated in Fig. 3, the redistribution layer RDL1 is formed over the upper surface of the sealing body SS1, and the redistribution layer RDL2 is formed below the bottom surface of the sealing body SS1. Therefore, the plane size of the structure body POP1 illustrated in Fig. 3 can be smaller than the plane size of the structure body POP (R) illustrated in Fig. 2. That is, the electronic device including the structure body POP1 illustrated in Figs. 1C and 3 can be smaller than the electronic device including the structure body POP(R) illustrated in Figs. 1B and 2. Therefore, from the viewpoint of reducing the electronic device in size, most desirably, the electronic device includes the structure body POP1 illustrated in Fig. 1C.

However, it is apparent that the electronic device including the structure body POP1 illustrated in Figs. 1C and 3 is required to be improved, in particular, from the viewpoint of the heat release characteristic and the electric characteristic thereof. Thus, the request for the improvement will be described below.

### <The study of the improvement>

First, in the structure body POP1 illustrated in Fig. 3, the lid LID as represented in the structure body POP(R) illustrated in Fig. 2 is not provided. The lid LID provided in the structure body POP(R) illustrated in Fig. 2 has the function of efficiently releasing heat generated from the semiconductor chip CHP1 buried in the sealing body SS into the external space. In particular, in the structure body POP (R) illustrated in Fig. 2, the lid LID is exposed to air, so that the heat release effect of heat generated from the semiconductor chip CHP1 can be improved. Therefore, in the structure body POP(R) illustrated in Fig. 2, the heat release characteristic of the electronic device becomes good.

On the contrary, in the structure body POP1 illustrated in Fig. 3 that promotes the size reduction of the electronic device, the lid LID for improving the heat release effect of heat generated from the semiconductor chip CHP1 is not provided. Consequently, in the structure body POP1 illustrated in Fig. 3, the heat release efficiency of heat generated in the semiconductor chip CHP1 buried in the sealing body SS1 becomes poor. This means that the temperature of the semiconductor chip CHP1 buried in the sealing body SS1 is likely to be increased, so that the lowering of the reliability of the electronic device, typified by the malfunction of the integrated circuit (control circuit) formed in the semiconductor chip CHP1 is likely to occur.

Further, in the structure body POP1 illustrated in Fig. 3, the semiconductor devices MP1 and MP2 including the high-speed memories are arranged over the semiconductor chip CHP1 buried in the interior of the sealing body SS1. Consequently, the heat release path for heat generated from the semiconductor chip CHP1 cannot sufficiently function above the semiconductor chip CHP1. That is, the heat release path for heat generated from the semiconductor chip CHP1 functions mainly below the semiconductor chip CHP1.

On the other hand, as illustrated in Fig. 3, in the structure body POP1, the redistribution layer RDL2 is formed below the semiconductor chip CHP1. In particular, as illustrated in Fig. 3, the thickness of the redistribution layer RDL2 formed below the bottom surface of the sealing body SS1 is larger than the thickness of the redistribution layer RDL1 formed over the upper surface of the sealing body SS1. This means that in the structure body POP1 illustrated in Fig. 3, due to the fact that the redistribution layer RDL2 having a larger thickness is formed below the semiconductor chip CHP1, it cannot be said that the heat release path for heat generated from the semiconductor chip CHP1 can sufficiently function below the semiconductor chip CHP1.

From the above, in the structure body POP1 illustrated in Fig. 3, the size reduction of the electronic device is prioritized, thereby adopting (1) a structure in which the lid LID is removed, (2) a structure in which the semiconductor devices MP1 and MP2 are arranged over the semiconductor chip CHP1, and (3) a structure in which the redistribution layer RDL2 having a larger thickness is formed below the semiconductor chip CHP1. And, in the structure body POP1 illustrated in Fig. 3, due to the structures represented in the above-described (1) to (3), the heat release efficiency of heat generated in the semiconductor chip CHP1 buried in the sealing body SS1 is lowered. That is, in the structure body POP1 illustrated in Fig. 3, since the size reduction of the electronic device is promoted, the request for the improvement due to the lowered heat release characteristic of the electronic device occurs. From this, although the structure body POP1 illustrated in Fig. 3 contributes to the size reduction of the electronic device, the range of products to which the structure body POP1 illustrated in Fig. 3 is applied is limited in consideration of the heat release characteristic. That is, the application of the structure body POP1 illustrated in Fig. 3 to the electronic device having large power consumption can affect the reliability of the electronic device. Therefore, in consideration of the heat release characteristic, the range of products to which the structure body POP1 illustrated in Fig. 3 is applied is limited to a mobile product having small power consumption, and consequently, the development of the structure body POP1 illustrated in Fig. 3 to the product having large power consumption, typified by, for example, in-vehicle application, security camera application, and the like, is difficult.

Successively, in the structure body POP1 illustrated in Fig. 3, the semiconductor chip CHP1 buried in the sealing body SS1 is formed with the control circuit controlling the high-speed memories included in the semiconductor devices MP1 and MP2. Therefore, the semiconductor chip CHP1 and the semiconductor device MP1 (MP2) are required to be electrically coupled. At this time, as illustrated in Fig. 3, the electric coupling between the semiconductor chip CHP1 and the semiconductor device MP1 (MP2) in the structure body POP1 is performed through the detour path, indicated by a thick arrow, in the order of the semiconductor chip CHP1, the redistribution layer RDL2, the through via TV, the redistribution layer RDL1, and the semiconductor device MP1 (MP2) . This means that in the structure body POP1 illustrated in Fig. 3, the electric coupling path between the semiconductor chip CHP1 and the semiconductor device MP1 (MP2) becomes longer. That is, in the structure body POP1 illustrated in Fig. 3, the parasitic impedance in the electric coupling path between the semiconductor chip CHP1 and the semiconductor device MP1 (MP2) is increased. And, in particular, the parasitic impedance increase can be an obstacle when the structure body POP1 illustrated in Fig. 3 is adopted to the electronic device corresponding to the next-generation high-speed memory such that the operation speed of the high-speed memory included in the semiconductor device MP1 (MP2) is further increased.

From the above, the structure body POP1 illustrated in Fig. 3 is the structure useful for achieving the size reduction of the electronic device, whereas it is found that the structure body POP1 is required to be improved from the viewpoint of the heat release characteristic and the electric characteristic thereof. Accordingly, in this embodiment, the structure body POP1 that is the structure useful for achieving the size reduction of the electronic device is contrived for improving the heat release characteristic and the electric characteristic while maintaining its basic structure. The technical idea according to this embodiment contrived for improving the heat release characteristic and the electric characteristic will be described below with reference to the drawings.

### <The structure of the electronic device>

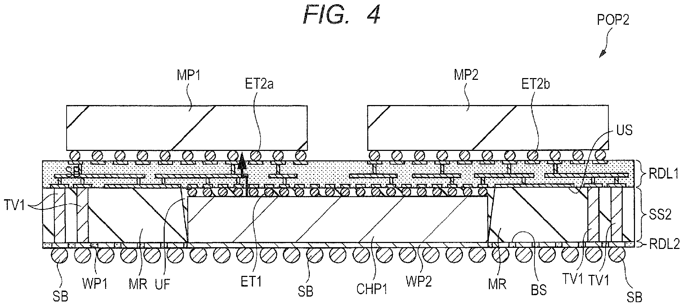

Fig. 4 is a schematic cross-sectional view illustrating a structure body structuring the electronic device according to this embodiment. In Fig. 4, a structure body POP2 according to this embodiment has a sealing body SS2. The sealing body SS2 seals the semiconductor chip CHP1 by the resin MR. And, a plurality of through vias TV1 passing through the resin MR are formed in the sealing body SS2. Further, the redistribution layer RDL1 formed by the application of the wafer process technique is formed over an upper surface US of the sealing body SS2. Furthermore, the semiconductor device MP1 and the semiconductor device MP2 are mounted through the redistribution layer RDL1 over the upper surface US of the sealing body SS2. On the contrary, the redistribution layer RDL2 formed by the application of the wafer process technique is formed below a bottom surface BS of the sealing body SS2. Further, the solder balls SB functioning as external terminals are arranged through the redistribution layer RDL2 below the bottom surface BS of the sealing body SS2. That is, the redistribution layer RDL2 has an opposite surface that can be opposite a mounting substrate (motherboard), not illustrated. And, the solder balls (ball terminals) SB electrically coupled to the wiring included in the redistribution layer RDL2 are arranged below the opposite surface of the redistribution layer RDL2.

As described above, the structure body POP2 structuring the electronic device according to this embodiment has the sealing body SS2, the semiconductor device MP1, and the semiconductor device MP2. At this time, the sealing body SS2 has the upper surface US, and the bottom surface BS positioned on the opposite side of the upper surface US. And, the structure body POP2 includes the redistribution layer RDL1 that is the wiring formed over the upper surface US of the sealing body SS2, and the redistribution layer RDL2 that is the wiring formed below the bottom surface BS of the sealing body SS2. Further, the sealing body SS2 has, in its interior, the semiconductor chip CHP1 sealed by the resin MR. In addition, the sealing body SS2 has the through vias TV1 functioning as through portions electrically coupling the redistribution layer RDL1 and the redistribution layer RDL2. The through vias TV1 are formed to pass through the resin MR of the sealing body SS2.

Next, the semiconductor device MP1 and the semiconductor device MP2 are mounted over the redistribution layer RDL1. That is, the structure body POP2 structuring the electronic device according to this embodiment includes a plurality of semiconductor devices mounted over the redistribution layer RDL1. In particular, as illustrated in Fig. 4, the semiconductor devices include the semiconductor device MP1, and the semiconductor device MP2 arranged side by side with the semiconductor device MP1 and spaced from the semiconductor device MP1 over the redistribution layer RDL1. However, the technical idea according to this embodiment is not limited to this, and is also applicable to a structure in which the single semiconductor device is mounted over the redistribution layer RDL1. Each of the semiconductor device MP1 and the semiconductor device MP2 includes a semiconductor chip (not illustrated) formed with a storage circuit structuring the high-speed memory, and external terminals ET2a (ET2b) electrically coupled to the semiconductor chip. And, the external terminals ET2a (ET2b) are electrically coupled to the wiring included in the redistribution layer RDL1. On the other hand, the solder balls SB functioning as external terminals are arranged below the redistribution layer RDL2.

The control circuit (integrated circuit) controlling the operation of the high-speed memory incorporated in the semiconductor device MP1 (MP2) is formed in the semiconductor chip CHP1 buried in the sealing body SS2. The semiconductor chip CHP1 is provided with coupling terminals ET1. The control circuit formed in the semiconductor chip CHP1 is electrically coupled to the semiconductor device MP1 (MP2) through the path in the order of the coupling terminal ET1, the wiring included in the redistribution layer RDL1, the external terminal ET2a (ET2b) provided below the semiconductor device MP1 (MP2), and the high-speed memory. In addition, the control circuit formed in the semiconductor chip CHP1 can be electrically coupled to an external device through the path in the order of the coupling terminal ET1, the wiring included in the redistribution layer RDL1, the through via TV1, the wiring included in the redistribution layer RDL2, and the solder ball SB. As described above, the semiconductor chip CHP1 and the redistribution layer RDL1 are coupled via the coupling terminals ET1. The electric coupling between the semiconductor chip CHP1 and the semiconductor device MP1 (MP2) is performed only by the coupling terminals ET1 and the redistribution layer RDL1. That is, in the structure body POP2 according to this embodiment, the electric coupling path between the semiconductor chip CHP1 and the semiconductor device MP1 (MP2) does not include the through vias TV1 and the redistribution layer RDL2.

At this time, for example, as illustrated in Fig. 4, the thickness of the redistribution layer RDL1 is larger than the thickness of the redistribution layer RDL2. In other words, the thickness of the redistribution RDL2 is smaller than the thickness of the redistribution layer RDL1. Specifically, as illustrated in Fig. 4, the number of wiring layers of the redistribution layer RDL1 is larger than the number of wiring layers of the redistribution layer RDL2. As an example, the redistribution layer RDL1 includes a multi-layered wiring, whereas the redistribution layer RDL2 includes a single-layered wiring. And, as illustrated in Fig. 4, in this embodiment, the single-layered wiring structuring the redistribution layer RDL2 has wiring patterns WP1 coupled to the through vias TV1, and a wiring pattern WP2 coupled to the semiconductor chip CHP1 and having a larger plane area than each wiring pattern WP1. In this embodiment, the wiring pattern WP1 mainly has the function of transmitting an electric signal, whereas the wiring pattern WP2 mainly has the function of transmitting heat.

### <The structure of electronic equipment>

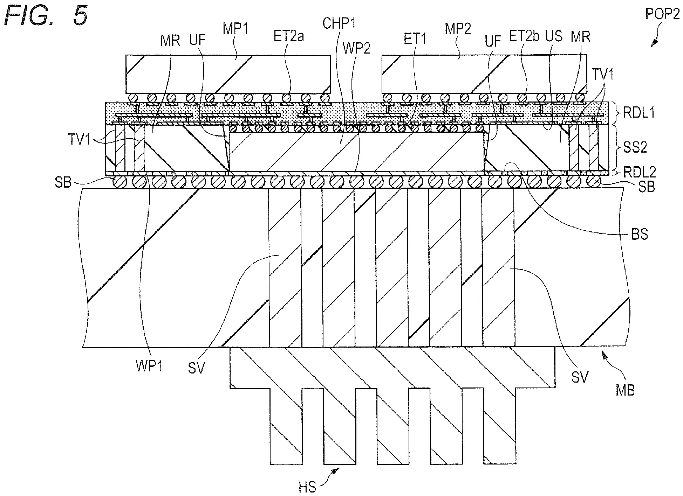

Successively, the structure of electronic equipment according to this embodiment will be described. Fig. 5 is a schematic cross-sectional view illustrating part of the structure of the electronic equipment according to this embodiment. Herein, the "electronic equipment" has the structure body POP2 structuring the electronic device according to this embodiment mounted over a motherboard (mounting substrate) MB. In Fig. 5, in the electronic equipment according to this embodiment, the structure body POP2 illustrated in Fig. 4 is mounted over the motherboard MB.

Here, as illustrated in Fig. 5, the motherboard MB according to this embodiment has a heat release structure for releasing heat generated from the semiconductor chip CHP1 at the position overlapped with the semiconductor chip CHP1 in plan view. Specifically, the heat release structure formed in the motherboard MB includes a plurality of thermal vias SV formed to pass through the motherboard MB, and heat release fins HS coupled to the respective thermal vias SV and provided below the bottom surface of the motherboard MB.

Further, although not illustrated in Fig. 5, an electronic component whose operation is controlled by the control circuit formed in the semiconductor chip CHP1 is mounted over the the motherboard MB according to this embodiment. That is, besides the structure body POP2 structuring the electronic device according to this embodiment, the electronic component electrically coupled to the structure body POP2 is also mounted over the the motherboard MB according to this embodiment. In this case, for example, the semiconductor chip CHP1 present in the interior of the structure body POP2 has a control circuit (first control circuit) controlling the operation of the semiconductor device MP1 and the semiconductor device MP2, and a control circuit (second control circuit) controlling the operation of the electronic component arranged over the motherboard MB. At this time, for example, the operation speed of the semiconductor device MP1 (MP2) is higher than the operation speed of the electronic component mounted over the motherboard MB.

For example, as illustrated in Fig. 5, the electric coupling between the semiconductor chip CHP1 and the electronic component (not illustrated) is performed through the coupling path in the order of the redistribution layer RDL1, the through via TV1, the redistribution layer RDL2, the solder ball SB, and the wiring over the motherboard MB.

### <Features according to this embodiment>

Next, feature points according to this embodiment will be described. A first feature point according to this embodiment is in that, for example, as illustrated in Fig. 4, the thickness of the redistribution layer RDL2 formed below the bottom surface BS of the sealing body SS2 is smaller than the thickness of the redistribution layer RDL1 formed over the upper surface US of the sealing body SS2. With this, according to this embodiment, the heat release efficiency from the bottom surface of the sealing body SS2 can be improved. That is, according to this embodiment, heat generated in the semiconductor chip CHP1 is released to below the sealing body SS2, and in place of the redistribution layer RDL1 having a larger thickness, the redistribution layer RDL2 having a smaller thickness is present in the heat release path. As a result, according to this embodiment, the heat release efficiency when heat generated in the semiconductor chip CHP1 is released to below the sealing body SS2 can be improved. Therefore, according to this embodiment, while the same basic structure as the structure body POP1 (see Fig. 3) that is the structure useful for achieving the size reduction of the electronic device is adopted, the adoption of the above-described first feature point according to this embodiment can improve the heat release characteristic of the electronic device. That is, the adoption of the structure body POP2 (see Fig. 4) according to this embodiment can provide the electronic device that can improve both the size reduction and the heat release characteristic. From this, the structure body POP2 according to this embodiment is applicable to a mobile product having small power consumption, and can also be developed to a product having large power consumption, typified by in-vehicle application, security camera application, and the like. In this way, the structure body POP2 including the first feature point according to this embodiment is applicable, not only to the mobile product, but also to the electronic device used in a wide range of products, such as in-vehicle application, security camera application, and the like. And, the structure body POP2 including the first feature point according to this embodiment is excellent in achieving the improvement in both the size reduction and the heat release characteristic in a wide range of products.

Successively, a second feature point according to this embodiment is in that, for example, as illustrated in Fig. 4, the wiring pattern WP2 included in the redistribution layer RDL2 formed below the bottom surface BS of the sealing body SS2 includes a wide pattern having about the same area as the plane size of the semiconductor chip CHP1. And, the second feature point according to this embodiment is in that the wide pattern is arranged to be overlapped with the semiconductor chip CHP1 in plan view. With this, the structure body POP2 structuring the electronic device according to this embodiment can efficiently release heat generated in the semiconductor chip CHP1 from the wide pattern to the outside of the structure body POP2. In particular, the first feature point and the second feature point according to this embodiment are combined, so that the heat release efficiency of the electronic device can be further improved.

Next, a third feature point according to this embodiment is in that, for example, as illustrated in Fig. 5, as the main heat release path for heat generated from the semiconductor chip CHP1, the heat release path from the bottom surface BS side of the sealing body SS2 is noted to improve the heat release efficiency from the bottom surface BS side of the sealing body SS2. That is, the heat release path from the bottom surface BS side of the sealing body SS2 of the structure body POP2 becomes the path in the order of the semiconductor chip CHP1, the wiring pattern WP2 structuring the redistribution layer RDL2, and the solder ball SB. And as illustrated in Fig. 5, the structure body POP2 structuring the electronic device according to this embodiment is mounted over the motherboard MB. At this time, heat transmitted from the semiconductor chip CHP1 as a heat source through the wiring pattern WP2 structuring the redistribution layer RDL2 to the solder balls SB is transmitted onto the motherboard MB. Therefore, for example, as illustrated in Fig. 5, the thermal vias SV and the heat release fins HS are provided in the region of the motherboard MB overlapped with the semiconductor chip CHP1 in plan view. With this, heat transmitted from the the semiconductor chip CHP1 as a heat source through the wiring pattern WP2 structuring the redistribution layer RDL2 to the solder balls SB can be immediately released into the external space by the thermal vias SV and the heat release fins HS provided in the motherboard MB.

In this way, in this embodiment, in the structure body POP2 structuring the electronic device, the heat release path from the bottom surface BS side of the sealing body SS2 is noted to provide the contrivance points (the first feature point and the second feature point) for improving the heat release efficiency from the bottom surface BS side of the sealing body SS2. And, as illustrated in Fig. 5, the bottom surface BS side of the sealing body SS2 is the side mounting the structure body POP2 over the motherboard MB, so that besides the contrivance points for improving the heat release efficiency of the structure body POP2 structuring the electronic device, the usefulness providing the contrivance point for improving the heat release efficiency of the motherboard MB can be enhanced. That is, by providing the heat release structure (the thermal vias SV and the heat release fins HS) in the motherboard MB, heat transmitted from the semiconductor chip CHP1 as a heat source through the wiring pattern WP2 structuring the redistribution layer RDL2 to the solder balls SB can be immediately released from the motherboard MB into the external space.

As described above, in this embodiment, the heat release path from the bottom surface BS side of the sealing body SS2 is noted to improve the heat release efficiency from the bottom surface BS side of the sealing body SS2. For this, besides the contrivance points (the first feature point and the second feature point) for improving the heat release efficiency of the structure body POP2 structuring the electronic device, further, the contrivance point for improving the heat release efficiency of the motherboard MB mounting the structure body POP2 (the thermal vias SV and the heat release fins HS) can be provided. That is, the third feature point according to this embodiment can combine the contrivance points of the structure body POP2 and the contrivance point of the motherboard MB, and thus has a large technical meaning from the viewpoint of improving the heat release efficiency.

Successively, a fourth feature point according to this embodiment is in that the semiconductor chip CHP1 is arranged in the sealing body SS2 so that the coupling terminals ET1 of the semiconductor chip CHP1 face upward and the coupling terminals ET1 of the semiconductor chip CHP1 are electrically coupled to the wiring included in the redistribution layer RDL1 having a larger thickness (multi-layered wiring layer). First, since the coupling terminals ET1 of the semiconductor chip CHP1 face upward, the distance between the semiconductor device MP1 (MP2) arranged over the semiconductor chip CHP1 and the coupling terminals ET1 of the semiconductor chip CHP1 can be shorter. And, the redistribution layer RDL1 having a larger thickness (multi-layered wiring layer) can couple the coupling terminals ET1 of the semiconductor chip CHP1 and the external terminals ET2a (ET2b) of the semiconductor device MP1 (MP2). With this, in the fourth feature point according to this embodiment, for example, in Fig. 4, the electric coupling path between the semiconductor chip CHP1 and the semiconductor device MP1 (MP2) can be shorter. Specifically, as indicated by the thick arrow in Fig. 4, the electric coupling path between the semiconductor chip CHP1 and the semiconductor device MP1 (MP2) becomes the path in the order of the coupling terminal ET1 of the semiconductor chip CHP1, the wiring included in the redistribution layer RDL1, and the external terminal ET2a (ET2b) of the semiconductor device MP1 (MP2) . As a result, in the structure body POP2 illustrated in Fig. 4, the parasitic impedance in the electric coupling path between the semiconductor chip CHP1 and the semiconductor device MP1 (MP2) can be reduced. From this, by the parasitic impedance reduction, in particular, the structure body POP2 illustrated in Fig. 4 can be adopted to the electronic device corresponding to the next-generation high-speed memory such that the operation speed of the high-speed memory included in the semiconductor device MP1 (MP2) is further increased.

Here, when the fourth feature point according to this embodiment is adopted, for example, in Fig. 5, the electric coupling between the semiconductor chip CHP1 and the electronic component mounted over the motherboard MB (not illustrated) is performed through the coupling path in the order of the coupling terminal ET1 of the semiconductor chip CHP1, the redistribution layer RDL1, the through via TV1, the redistribution layer RDL2, the solder ball SB, and the wiring over the motherboard MB. That is, when the fourth feature point according to this embodiment is adopted, the coupling path between the semiconductor chip CHP1 and the semiconductor device MP1 (MP2) can be shorter, whereas the coupling path between the semiconductor chip CHP1 and the electronic component mounted over the motherboard MB (not illustrated) becomes longer. For this, for example, when the electronic component mounted over the motherboard MB is controlled by the control circuit formed in the semiconductor chip CHP1, the operation speed of the electronic component is desirably lower than the operation speed of the semiconductor device MP1 (MP2). This is because when the fourth feature point according to this embodiment is adopted, the coupling path between the semiconductor chip CHP1 and the electronic component mounted over the motherboard MB becomes longer than the coupling path between the semiconductor chip CHP1 and the semiconductor device MP1 (MP2) . That is, the longer coupling path means that the parasitic impedance is increased, and the parasitic impedance increase means that the high-speed operation becomes difficult.

Next, a fifth feature point according to this embodiment is in that for example, as illustrated in Fig. 4, the semiconductor device MP1 (MP2) is arranged over the redistribution layer RDL1 in the state of the package structure body. With this, the reliability of the structure body POP2 structuring the electronic device according to this embodiment can be improved.

For example, from the viewpoint of the size reduction of the structure body POP2, it is considered that the semiconductor chip formed with the high-speed memory is arranged over the redistribution layer RDL1 in the bare chip state. However, in this case, the semiconductor chip in the bare chip state is subjected to an electric characteristic examination, but is not subjected to a burn-in examination (screening examination) for detecting initial failure. For this, it is considered that after the semiconductor chip that has passed the electric characteristic examination is arranged over the redistribution layer RDL1 in the bare chip state, the semiconductor chip in the bare chip state leads to initial failure by the initial operation of the electronic device. In this case, the electronic device fails, so that the reliability of the electronic device is lowered. On the contrary, in this embodiment, as illustrated in Fig. 4, the semiconductor device MP1 (MP2) is arranged over the redistribution layer RDL1 in the state of the package structure body. At this time, the semiconductor device MP1 (MP2) of the package structure body is subjected, not only to the electric characteristic examination, but also to the burn-in examination for detecting initial failure. Thus, the semiconductor device MP1 (MP2) that has passed, not only the electric characteristic examination, but also the burn-in examination, is arranged over the redistribution layer RDL1 in the state of the package structure body. As a result, the reliability of the electronic device including the structure body POP2 according to this embodiment illustrated in Fig. 4 can be improved.

### <A method for manufacturing the electronic device>

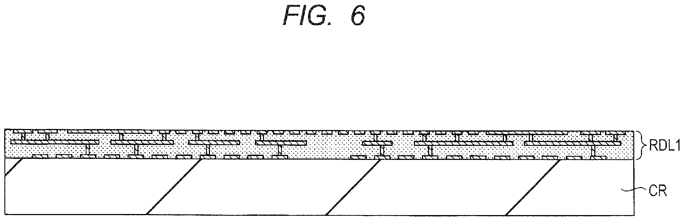

Successively, a method for manufacturing the electronic device according to this embodiment will be described with reference to the drawings. First, as illustrated in Fig. 6, the redistribution layer RDL1 is formed over a support member CR. For example, in the redistribution layer RDL1, a polyimide resin film is coated onto the support member CR, and an opening is then formed in the polyimide resin film by using the photolithography technique. Thereafter, a copper film is formed in the interior of the opening by the plating method. As a result, a copper wiring including the copper film can be formed in the interior of the opening of the polyimide resin film. And, the above-described process for forming the copper wiring is repeated, so that the redistribution layer RDL1 including a multi-layered wiring layer can be formed.

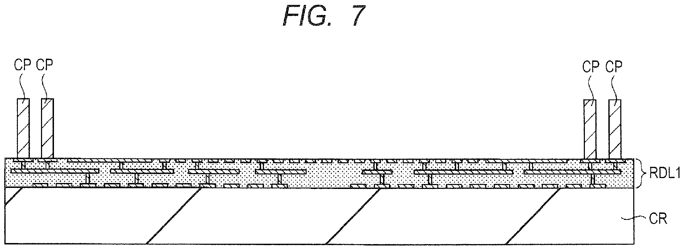

Next, a resist film is coated onto the redistribution layer RDL1, and an opening is then formed in the resist film by using the photolithography technique. Thereafter, a copper film is formed in the interior of the opening by using the plating method. It should be noted that a solder film may be formed over the copper film. And, as illustrated in Fig. 7, the resist film is removed to form copper posts CP. In this way, the copper posts (protrusions) CP protruding from the redistribution layer RDL1 and electrically coupled to the redistribution layer RDL1 can be formed over the redistribution layer RDL1.

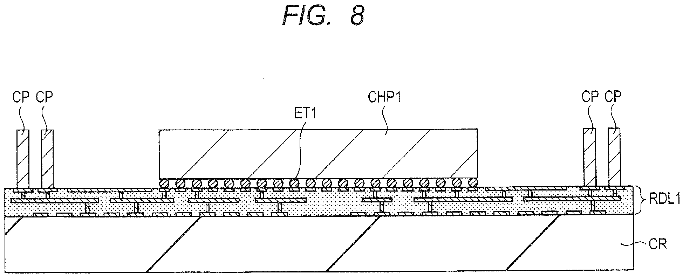

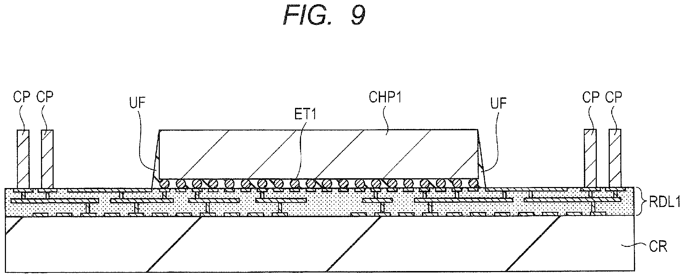

Successively, as illustrated in Fig. 8, the semiconductor chip CHP1 formed with the coupling terminals ET1 is mounted over the redistribution layer RDL1. Specifically, the semiconductor chip CHP1 is mounted over the redistribution layer RDL1 to be spaced from the copper posts CP in plan view. And, as illustrated in Fig. 9, underfill UF is filled into the gap between the semiconductor chip CHP1 and the redistribution layer RDL1.

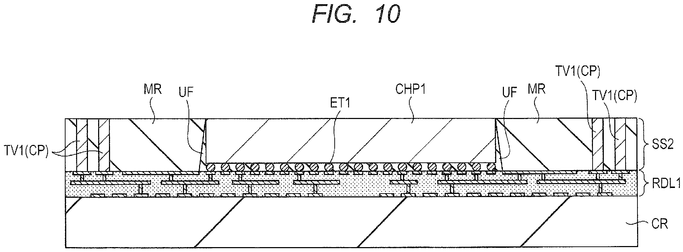

Thereafter, as illustrated in Fig. 10, the resin MR is formed to cover the semiconductor chip CHP1 and the copper posts CP. And, the upper surface of the semiconductor chip CHP1 and the upper surfaces of the copper posts CP are exposed. With this, the sealing body SS2 sealing the semiconductor chip CHP1 can be formed over the redistribution layer RDL1. At this time, the copper posts CP become the through vias TV1 passing through the sealing body SS2.

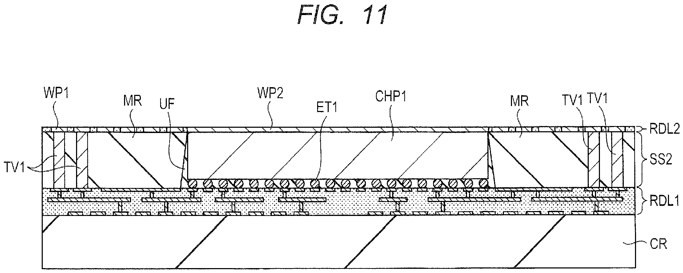

Next, as illustrated in Fig. 11, the redistribution layer RDL2 electrically coupled to the through vias TV1 and the semiconductor chip CHP1 and having a smaller thickness than the redistribution layer RDL1 is formed over the sealing body SS2. At this time, the wiring patterns WP1 electrically coupled to the through vias TV1 and the wiring pattern WP2 including the wide pattern having about the same plane area as the semiconductor chip CHP1 are formed in the redistribution layer RDL2. At this time, the wiring pattern WP2 is formed at the position overlapped with the semiconductor chip CHP1 in plan view.

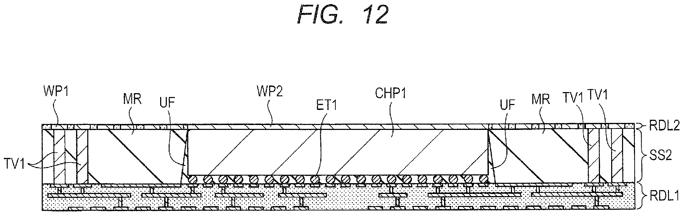

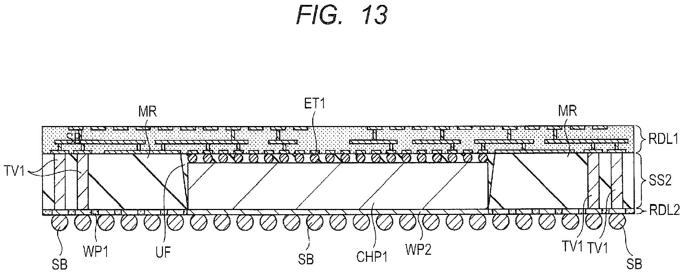

Successively, as illustrated in Fig. 12, the redistribution layer RDL1 is separated from the support member CR. And, as illustrated in Fig. 13, the sealing body SS2 below which the redistribution layer RDL1 is formed and over which the redistribution layer RDL2 is formed is inverted so that the redistribution layer RDL2 is arranged below the sealing body SS2. Thereafter, the solder balls SB are coupled to the redistribution layer RDL2.

And, as illustrated in Fig. 4, the semiconductor device MP1 (MP2) electrically coupled to the redistribution layer RDL1 is mounted over the redistribution layer RDL1. In the above manner, the structure body POP2 structuring the electronic device according to this embodiment can be manufactured.

### <A method for manufacturing the electronic equipment>

In a method for manufacturing the electronic equipment according to this embodiment, the structure body POP2 manufactured as above is provided, and then, as illustrated in Fig. 5, the structure body POP2 is mounted through the solder balls SB over the motherboard MB in a state where the redistribution layer RDL2 is opposite the motherboard (mounting substrate) MB. With this, the electronic equipment according to this embodiment can be manufactured.

### <First Modification>

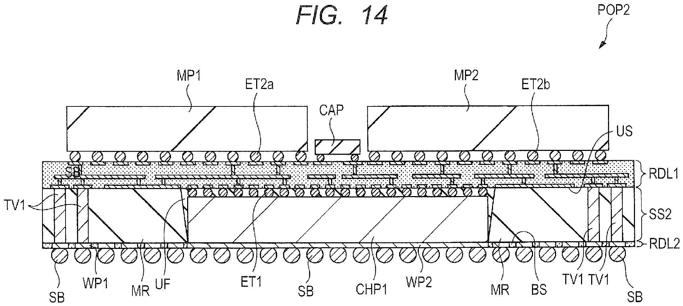

Fig. 14 is a schematic diagram of the structure body POP2 structuring the electronic device according to a first modification. In Fig. 14, in the structure body POP2 according to the first modification, a capacitor CAP electrically coupled to the semiconductor chip CHP1 is mounted over the redistribution layer RDL1 between the semiconductor device MP1 and the semiconductor device MP2. For example, the capacitor CAP is provided between a power source wire for supplying a power source potential to the integrated circuit formed in the semiconductor chip CHP1 and a ground wire for supplying a ground potential (reference potential) to the integrated circuit formed in the semiconductor chip CHP1. With this, the structure body POP2 according to this modification can improve the stability of the power source potential and the ground potential supplied to the semiconductor chip CHP1.

Further, as illustrated in Fig. 14, in the structure body POP2 according to the first modification, the capacitor CAP is arranged above the center of the semiconductor chip CHP1. As a result, the semiconductor device MP1 and the semiconductor device MP2 arranged to interpose the capacitor CAP therebetween are arranged to avoid the center of the semiconductor chip CHP1 having a large amount of heat generated. Therefore, the structure body POP2 according to the first modification can prevent heat generated in the semiconductor chip CHP1 from affecting the semiconductor device MP1 and the semiconductor device MP2.

Further, as illustrated in Fig. 14, in the structure body POP2 according to the first modification, a space is provided above the center of the semiconductor chip CHP1 having a large amount of heat generated, so that the release effect of heat from this space can be expected, so that the heat release efficiency can be improved.

### <Second Modification>

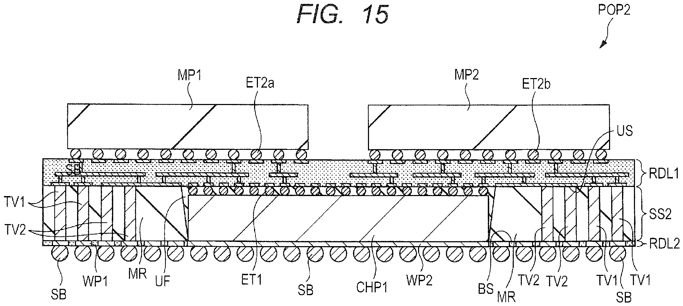

Fig. 15 is a schematic diagram of the structure body POP2 structuring the electronic device according to a second modification. In Fig. 15, in the structure body POP2 according to the second modification, besides the through vias TV1 passing through the sealing body SS2, heat releasing through vias TV2 passing through the sealing body SS2 are formed. Specifically, in Fig. 15, the through vias TV1 mainly have the function of electrically coupling the wiring included in the redistribution layer RDL1 and the wiring included in the redistribution layer RDL2. On the contrary, the heat releasing through vias TV2 mainly have the function of releasing heat generated from the semiconductor chip CHP1 sealed in the sealing body SS2. By providing such the heat releasing through vias TV2, heat generated in the semiconductor chip CHP1 can be efficiently released to the outside of the structure body POP2. In particular, as illustrated in Fig. 15, from the viewpoint of efficiently releasing heat generated from the semiconductor chip CHP1 to the outside of the structure body POP2, the heat releasing through vias TV2 are desirably formed at the positions near the semiconductor chip CHP1 with respect to the through vias TV1. That is, from the viewpoint of improving the heat release efficiency of the structure body POP2 according to the second modification, the distance between the semiconductor chip CHP1 and the heat releasing through vias TV2 is desirably shorter than the distance between the semiconductor chip CHP1 and the through vias TV1.

The inventions made by the present inventors have been specifically described above based on the embodiment, but the present invention is not limited to the embodiment, and needless to say, various modifications can be made in the scope not departing from its purport. The embodiment includes the following forms.

### Addition 1

A method for manufacturing an electronic device includes the steps of (a) forming a first wiring over a support member, (b) forming, over the first wiring, a protrusion protruding from the first wiring and electrically coupled to the first wiring, (c) after the step (b), mounting a first semiconductor chip over the first wiring spaced from the protrusion in plan view, (d) after the step (c), forming, over the first wiring, a sealing body sealing the protrusion and the first semiconductor chip, (e) after the step (d), forming, over the sealing body, a second wiring electrically coupled to the protrusion and the first semiconductor chip and having a smaller thickness than the first wiring, (f) after the step (e), separating the first wiring from the support member, and (g) after the step (f), mounting, over the first wiring, a semiconductor device electrically coupled to the first wiring.

### Addition 2

A method for manufacturing electronic equipment includes the steps of (a) providing an electronic device including a sealing body having a first upper surface and a first bottom surface positioned on the opposite side of the first upper surface and sealing a first semiconductor chip in the interior of the sealing body, a first wiring formed over the first upper surface, a second wiring formed below the first bottom surface, a through portion passing through the sealing body and electrically coupling the first wiring and the second wiring, a semiconductor device mounted over the first wiring, the first semiconductor chip being electrically coupled to the first wiring, the first semiconductor chip being electrically coupled to the second wiring, the semiconductor device being electrically coupled to the first wiring, and the thickness of the second wiring being smaller than the thickness of the first wiring, and (b) after the step (a), mounting the electronic device over a mounting substrate in a state where the second wiring is opposite the mounting substrate.

## Claims

1. An electronic device comprising:
a sealing body having a first upper surface and a first bottom surface positioned on the opposite side of the first upper surface and sealing a first semiconductor chip in the interior of the sealing body;
a first wiring formed over the first upper surface;
a second wiring formed below the first bottom surface;
a through portion passing through the sealing body and electrically coupling the first wiring and the second wiring;
a semiconductor device mounted over the first wiring;
the first semiconductor chip being electrically coupled to the first wiring;
the first semiconductor chip being electrically coupled to the second wiring;
the semiconductor device being electrically coupled to the first wiring, and
the thickness of the second wiring being smaller than the thickness of the first wiring.

2. The electronic device according to Claim 1,
wherein the second wiring has:
a first pattern coupled to the through portion, and
a second pattern coupled to the first semiconductor chip and having a larger plane area than the first pattern.

3. The electronic device according to Claim 1,
wherein the number of wiring layers of the first wiring is larger than the number of wiring layers of the second wiring.

4. The electronic device according to Claim 3,
wherein the first wiring includes a multi-layered wiring,
wherein the second wiring includes a single-layered wiring.

5. The electronic device according to Claim 1,
wherein the first semiconductor chip and the first wiring are coupled through a coupling terminal,
wherein the electric coupling between the first semiconductor chip and the semiconductor device is performed only by the coupling terminal and the first wiring.

6. The electronic device according to Claim 1,
wherein the electric coupling path between the first semiconductor chip and the semiconductor device does not include the through portion and the second wiring.

7. The electronic device according to Claim 1,
wherein the electronic device includes a plurality of semiconductor devices mounted over the first wiring.

8. The electronic device according to Claim 7,
wherein the semiconductor devices include:
a first semiconductor device, and
a second semiconductor device arranged side by side with the first semiconductor device and spaced from the first semiconductor device over the first wiring.

9. The electronic device according to Claim 8,
wherein a capacitor electrically coupled to the first semiconductor chip is mounted over the first wiring between the first semiconductor device and the second semiconductor device.

10. The electronic device according to Claim 1,
wherein the sealing body has a heat releasing through portion different from the through portion.

11. The electronic device according to Claim 10,
wherein the distance between the first semiconductor chip and the heat releasing through portion is shorter than the distance between the first semiconductor chip and the through portion.

12. The electronic device according to Claim 1,
wherein the semiconductor device includes:
a second semiconductor chip; and
an external terminal electrically coupled to the second semiconductor chip,
wherein the external terminal is coupled to the first wiring.

13. The electronic device according to Claim 1,
wherein the semiconductor device is a semiconductor storage device storing information,
wherein the first semiconductor chip has a control circuit controlling the operation of the semiconductor storage device.

14. The electronic device according to Claim 1,
wherein the second wiring has an opposite surface that can be opposite a mounting substrate,
wherein a ball terminal coupled to the second wiring is arranged below the opposite surface of the second wiring.

15. Electronic equipment comprising:
(a) an electronic device including:
a sealing body having a first upper surface and a first bottom surface positioned on the opposite side of the first upper surface and sealing a first semiconductor chip in the interior of the sealing body;
a first wiring formed over the first upper surface;
a second wiring formed below the first bottom surface;
a through portion passing through the sealing body and electrically coupling the first wiring and the second wiring;
a semiconductor device mounted over the first wiring;
the first semiconductor chip being electrically coupled to the first wiring;
the first semiconductor chip being electrically coupled to the second wiring;
the semiconductor device being electrically coupled to the first wiring; and
the thickness of the second wiring being smaller than the thickness of the first wiring; and
(b) a mounting substrate over which the electronic device is mounted,
wherein the electronic device is mounted over the mounting substrate in a state where the second wiring is opposite the mounting substrate.

16. The electronic equipment according to Claim 15,
wherein the mounting substrate has a heat release structure for releasing heat generated from the first semiconductor chip at the position overlapped with the first semiconductor chip in plan view.

17. The electronic equipment according to Claim 15,
wherein an electronic component whose operation is controlled by a control circuit formed in the first semiconductor chip is mounted over the mounting substrate.

18. The electronic equipment according to Claim 15,
wherein the first semiconductor chip has:
a first control circuit controlling the operation of the semiconductor device, and
a second control circuit controlling the operation of the electronic component arranged over the mounting substrate.

19. The electronic equipment according to Claim 18,
wherein the operation speed of the semiconductor device is higher than the operation speed of the electronic component.

20. The electronic equipment according to Claim 18,
wherein the electric coupling between the first semiconductor chip and the electronic component is performed through the first wiring, the through portion, and the second wiring.
